# EUROPEAN PATENT APPLICATION

(11) **EP 4 119 588 A1**
(43) Date of publication of application: **18.01.2023**
(21) Application number: 21767616.2
(22) Date of filing: 17.02.2021
(51) Int. Cl.: C08F 220/20, C08F 220/22, C08F 220/26, H01L 21/027, B29C 59/02

(54) **PHOTOCURABLE RESIN COMPOSITION FOR IMPRINT MOLDING, RESIN MOLD, METHOD FOR FORMING PATTERN USING SAID RESIN MOLD, COMPOSITE MATERIAL HAVING SAID RESIN MOLD, METHOD FOR PRODUCING SAID COMPOSITE MATERIAL, AND METHOD FOR PRODUCING OPTICAL MEMBER**

(30) Priority: 10.03.2020 JP 2020040953
(71) Applicant: Toyo Gosei Co., Ltd., Ichikawa-shi, Chiba 272-0012 (JP)
(72) Inventor: TANAKA, Risa, Ichikawa-shi, Chiba 272-0012 (JP); KATO, Fuminobu, Ichikawa-shi, Chiba 272-0012 (JP); OSAKI, Takeshi, Ichikawa-shi, Chiba 272-0012 (JP)
(74) Representative: Strehl Schübel-Hopf & Partner
(86) International application number: PCT/JP2021/005950
(87) International publication number: WO 2021/182049

(57) **Abstract**

A photocurable resin composition for an imprint mold includes: a component (a): at least one of a fluorinated (meth)acrylate monomer having at least one (meth)acryloyloxy group and a dialkylsiloxane-based (meth)acrylate monomer having at least one (meth)acryloyloxy group; and a component (b): an acyclic bifunctional (meth)acrylate monomer having two (meth)acryloyloxy groups represented by the following formula (1), wherein a compounding ratio between the component (a) and the component (b) is 1 to 97 : 99 to 3 in terms of mass ratio, and the component (b) has a molecular weight of 700 or less.

## Description

### Technical Field

One aspect of the present invention relates to a curable resin composition for an imprint mold. Further, one aspect of the present invention relates to a resin mold obtained by using the curable resin composition for an imprint mold, a pattern forming method using the resin mold, a composite having the resin mold, a manufacturing method of the composite and a manufacturing method of an optical member.

### Background Art

In a manufacturing method of an optical member such as an optical or electronic component, an imprint technology is used in which a mold having an concave-convex pattern is pressed onto a photocurable resin composition for transfer to precisely transfer a fine pattern.

The imprint method generally includes four steps of (1) a step of applying a photocurable composition for transfer, (2) a step of pressing the composition with a mold, (3) a step of transferring and curing (photocuring or heat-curing), and (4) a step of removing the mold from the cured product, makes nano-sized processing possible with a simple process. In addition, since the equipment is simple and high throughput is expected, it is expected as a fine processing technology that enables mass production at low cost. Therefore, efforts for practical use are in progress in various fields such as semiconductor devices, storage media, biotechnology, and optical members.

Various resin molds have been proposed as a mold used in the imprint method, and improvements are being made mainly on components having a high fluorine content from the viewpoint of mold releasability (See Non-Patent Document 1).

### Related Art Document

### Non-Patent Document

Non-Patent Document 1: Angew. Chem. Int. Ed. 2004, 43, 5796.

### SUMMARY OF INVENTION

### Technical Problem

The curable resin composition described in Non-Patent Document 1 is excellent in mold releasability. However, the composition includes a fluorinated urethane (meth)acrylate having a high fluorine content as a main component. Since the cost of the fluorinated urethane (meth)acrylate having a high fluorine content is high, there is a problem in terms of cost.

Further, the fluorinated urethane (meth)acrylate having a high fluorine content has a problem in compatibility with other components.

A photocurable resin composition for an imprint mold that can yield a resin mold having excellent mold releasability and durability and is low in cost is desired. Solution to Problem

The present invention has been made to solve the above-described problem, and the present inventors have found that the above problem can be solved by using a specific component in combination as a photocurable resin composition for an imprint mold to complete one aspect of the present invention.

One aspect of the present invention is a photocurable resin composition for an imprint mold, the composition including: a component (a): at least one of: a fluorinated (meth)acrylate monomer having at least one (meth)acryloyloxy group; and a dialkylsiloxane-based (meth)acrylate monomer having at least one (meth)acryloyloxy group; and
a component (b): an acyclic bifunctional (meth)acrylate monomer having two (meth)acryloyloxy groups represented by the following formula (1),
wherein a compounding ratio between the component (a) and the component (b) is 1 to 97 : 99 to 3 in terms of mass ratio, and
the component (b) has a molecular weight of 700 or less.

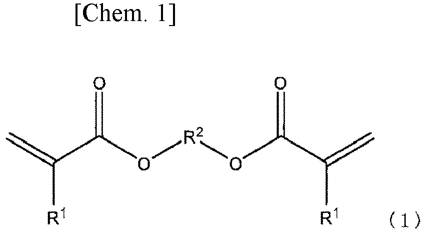

In the general formula (1), each R¹ is independently a hydrogen atom or a methyl group, and R² is a divalent organic group having no ring structure, and the divalent organic group having no ring structure includes at least one of: a linear alkylene group which may have a substituent; and a linear alkyleneoxy group which may have a substituent, wherein the substituent has 1 to 4 carbon atoms, and at least one of methylene groups included in the alkylene group and in the alkyleneoxy group may be replaced by a carbonyl group.

Another aspect of the present invention is a resin mold obtained by curing the photocurable resin composition for an imprint mold so as to have a plurality of concave-convex patterns.

Another aspect of the present invention is a pattern forming method, including: a step of forming a transfer layer on a base material using a photocurable resin composition for imprint transfer; a step of contacting the resin mold with a surface of the transfer layer; and a step of irradiating the transfer layer with light to form a concave-convex pattern.

Another aspect of the present invention is a composite having: the resin mold; and a photocured layer formed by irradiating the transfer layer with light in a state where the resin mold is contacted with the transfer layer.

Another aspect of the present invention is a method for manufacturing a composite, the method including: a step of forming a transfer layer on a base material using a photocurable resin composition for imprint transfer; a step of contacting the resin mold with a surface of the transfer layer; and a step of obtaining a composite having the resin mold and the photocured layer by irradiating the transfer layer with light to form a photocured layer having a concave-convex pattern.

Another aspect of the present invention is a method for manufacturing an optical member by using the pattern forming method to manufacture an optical member. Advantageous Effect of Invention

According to one aspect of the present invention, a resin mold having mold releasability and durability can be obtained, and a low-cost photocurable resin composition for an imprint mold can be provided.

### BRIEF DESCRIPTION OF DRAWINGS

FIG. 1 is a diagram illustrating an example of a process for manufacturing a resin mold according to one aspect of the present invention.
FIG. 2 is a diagram illustrating an example of a process for manufacturing a photocured layer from a resin mold according to one aspect of the present invention.

### DESCRIPTION OF EMBODIMENTS

### <1> Photocurable resin composition for an imprint mold

The photocurable resin composition for an imprint mold according to one aspect of the present invention includes: a component (a): at least one of: a fluorinated (meth)acrylate monomer having at least one (meth)acryloyloxy group; and a dialkylsiloxane-based (meth)acrylate monomer having at least one (meth)acryloyloxy group; and a component (b): the acyclic bifunctional (meth)acrylate monomer represented by the formula (1). In the photocurable resin composition for an imprint mold according to one aspect of the present invention, the compounding ratio between the component (a) and the component (b) is 1 to 97 : 99 to 3 in terms of mass ratio.

Each monomer component of the photocurable resin composition for an imprint mold according to one aspect of the present invention will be described below.

### [Component (a)]

The component (a) is at least one of: a fluorinated (meth)acrylate monomer having at least one (meth)acryloyloxy group (hereinafter, also referred to as "fluorinated component (a1)"); and a dialkylsiloxane-based (meth)acrylate monomer having at least one (meth)acryloyloxy group (hereinafter, also referred to as "siloxane-based component (a2)").

The fluorinated component (a1) preferably has a fluorine content of 30 to 65 mass%. The fluorine content is more preferably 35 mass% or more, further preferably 40 mass% or more, and particularly preferably 50 mass% or more.

### (Fluorinated component (a1))

The fluorinated component (a1) may be any fluorine-containing monomer having one or more (meth)acryloyloxy groups. The fluorinated component (a1) is preferably a monomer having one or two (meth)acryloyloxy groups, and more preferably a monomer having one (meth)acryloyloxy group.

When the fluorinated component (a1) is a monomer having one (meth)acryloyloxy group, the molecular weight is preferably 100 to 2500, more preferably 100 to 1000, and further preferably 200 to 700. When the fluorinated component (a1) is a monomer having two (meth)acryloyloxy groups, the molecular weight is preferably 100 to 3000, and more preferably 250 to 2500.

As the fluorinated component (a1), two or more types of fluorinated (meth)acrylate monomers having different structures may be used in combination.

As the fluorinated component (a1), a monofunctional or bifunctional fluorine atom-including (meth)acrylate including at least one of a fluorinated alkylene group and a fluorinated alkyleneoxy group is more preferable. By adjusting the molecular weight, good compatibility in the composition can be obtained. The fluorinated component (a1) preferably has 9 to 50 carbon atoms.

The fluorinated component (a1) may have a urethane bond.

Specific examples of the fluorinated component (a1) include the compounds indicated below. In the following formulas, R is a hydrogen atom or a methyl group. Of the following, n is preferably 0 to 9, p is preferably 0 to 18, and q is preferably 0 to 31.

The molecular weight when the fluorinated component (a1) is a polymer is calculated based on n, p and q which are calculated by ¹⁹F-NMR with reference to the method of the non-patent document (Macromol. Chem. Phys. 198, 1893-1907 (1997)).

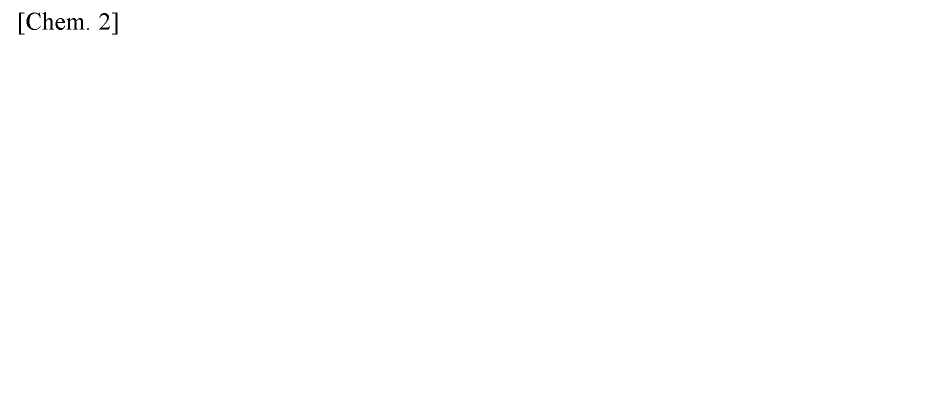

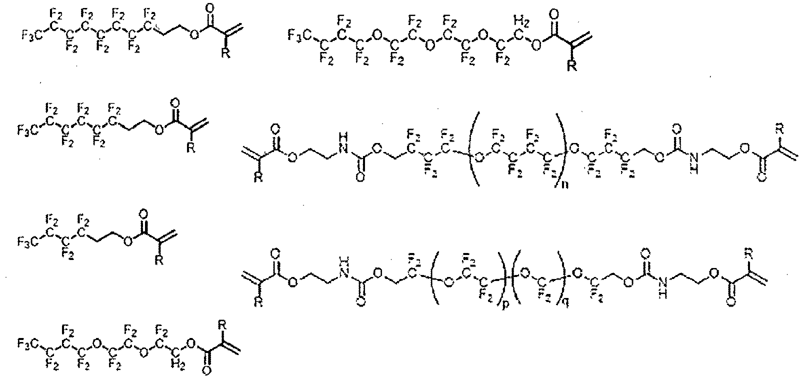

As the fluorinated component (a1), a commercially available one can be used.

When the fluorinated component (a1) is a fluorinated urethane (meth)acrylate, one may be used that is synthesized by a general method of reacting an alcohol with an isocyanate to obtain a urethane bond. At this time, raw materials in which at least one of the above alcohol and isocyanate is fluorinated is used. Specifically, the fluorinated urethane diacrylate represented by the following formula (A) can be synthesized as follows, for example.

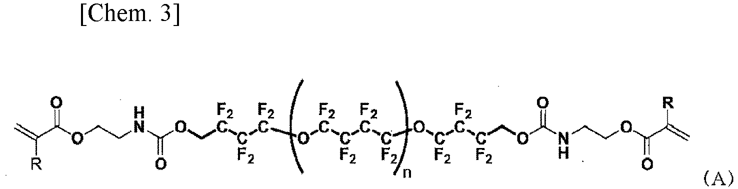

A fluorinated polytetramethylene glycol represented by the following formula (B) (product name "Fluorinated PTMG-250 DIOL", manufactured by Exfluor Research Corporation), 2-isocyanatoethyl acrylate (product name "Karenz AOI", manufactured by Showa Denko Co., Ltd.), and dibutyltin dilaurate as a catalyst are reacted at 70 to 90°C for 3 to 10 hours to obtain a fluorinated urethane diacrylate represented by the formula (A). The amount of each of the above compounds to be used may be appropriately determined within the same range as in the case of synthesizing a general urethane compound.

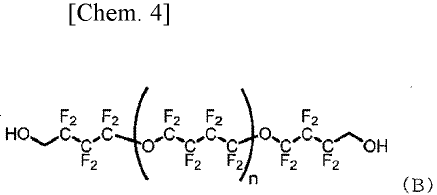

Further, the fluorinated urethane diacrylate represented by the following formula (C) can be synthesized, for example, as follows.

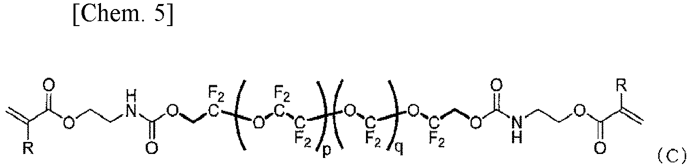

A fluorinated polyether represented by the following formula (D) (product name "D2", manufactured by Solvay Specialty Polymers Japan Co., Ltd.), 2-isocyanatothyl acrylate (product name "Karenz AOI", manufactured by Showa Denko Co., Ltd.), and dibutyltin dilaurate as a catalyst are reacted at 70 to 90 °C for 3 to 10 hours to obtain a fluorinated urethane diacrylate represented by the formula (C). The amount of each of the above compounds to be used may be appropriately determined within the same range as in the case of synthesizing a general urethane compound.

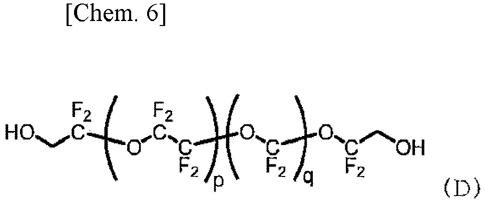

### (Siloxane-based component (a2))

The siloxane-based component (a2) is a dialkylsiloxane-based (meth)acrylate monomer having one or more (meth)acryloyloxy groups, and is preferably a monomer having the following structure.

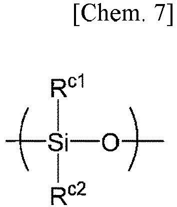

In the above formula, each of R^{c1} to R^{c2} is preferably an alkyl group having 1 to 4 carbon atoms independently, and more preferably an alkyl group having 1 to 2 carbon atoms. Examples of the alkyl group having 1 to 4 carbon atoms include a chain alkyl group such as a methyl group, an ethyl group, an n-propyl group and an n-butyl group.

As the siloxane-based component (a2), in addition to the monomer having the above structure, a monomer having a silsesquioxane skeleton represented by (R^{c3}SiO_{1.5})ₙ is also preferably used. R^{c3} is preferably an alkyl group having 1 to 4 carbon atoms.

Examples of the siloxane-based component (a2) include the compounds indicated below. In the following formulas, R is a hydrogen atom or a methyl group, and R' is an alkyl group having 1 to 4 carbon atoms.

As the siloxane-based component (a2), two or more types of siloxane-based (meth)acrylate monomers having different structures may be used in combination.

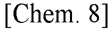

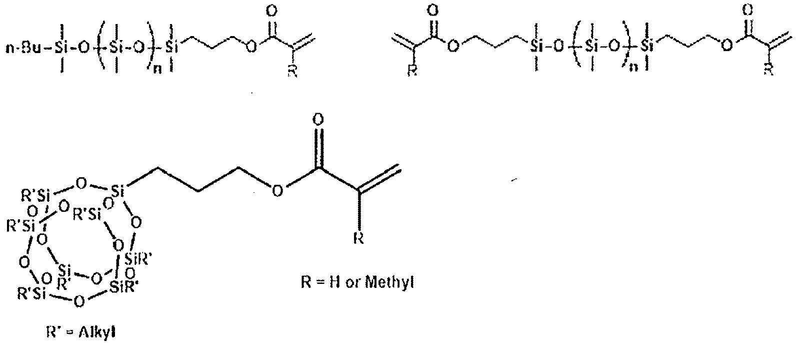

The siloxane-based component (a2) preferably has a molecular weight of 2000 or less, and more preferably 1000 or less. Further, the molecular weight of the siloxane-based component (a2) is preferably 600 or more.

In the photocurable resin composition for an imprint mold, the compounding ratio between the component (a) and the component (b) is preferably 1 to 97 : 99 to 3, more preferably1 to 50 : 99 to 50, and further preferably 5 to 30 : 95 to 70 in terms of mass ratio.

In the photocurable resin composition for an imprint mold, the compounding amount of the component (a) is preferably 1 to 35 mass% on a major component basis. It is more preferably 30 mass% or less, and further preferably 25 mass% or less. Further, it is more preferably 5 mass% or more, and further preferably 10 mass% or more. By setting the compounding amount within this range, the compatibility of the photocurable resin composition can be improved, and further, the mold releasability after photocuring can be exhibited.

The component (a) may be the component (a1) or the component (a2) alone, or may be a combination of the components (a1) and (a2). Further, as the component (a), a (meth)acrylate monomer having both a fluorine atom and a siloxane structure may be used.

### [Component (b)]

The component (b) is an acyclic bifunctional (meth)acrylate monomer represented by the following formula (1) having a molecular weight of 700 or less. The component (b) is a (meth)acrylate monomer other than the component (a), and is a monomer having neither a fluorine atom nor a siloxane structure.

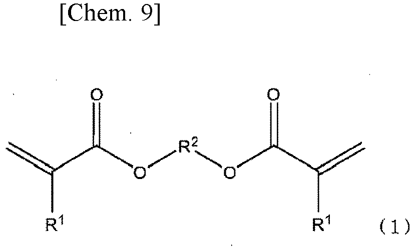

In the general formula (1), each R¹ is independently a hydrogen atom or a methyl group.

R² is a divalent organic group having no ring structure, and the divalent organic group having no ring structure includes at least one of: a linear alkylene group which may have a substituent (hereinafter, also referred to as "first substituent"); and a linear alkyleneoxy group which may have a substituent (hereinafter, also referred to as "second substituent"). The substituent has 1 to 4 carbon atoms, and at least one of methylene groups included in the alkylene group and in the alkyleneoxy group may be replaced by a carbonyl group.

The linear alkylene group which may have the first substituent preferably has at least one structure represented by the following formula (2).

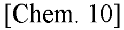

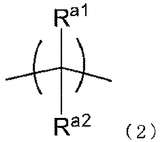

In the formula (2), R^{a1} to R^{a2} are each independently a hydrogen atom or the first substituent, and the first substituent is preferably an alkyl group having 1 to 4 carbon atoms.

The alkyleneoxy group which may have the second substituent preferably has at least one structure represented by the following formula (3).

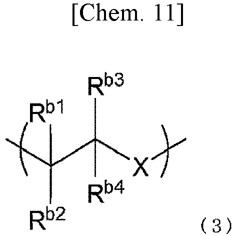

In the formula (3), R^{b1} to R^{b4} are each independently a hydrogen atom or the second substituent, and the second substituent is preferably an alkyl group having 1 to 4 carbon atoms. In the formula (3), X is preferably an oxygen atom or a sulfur atom.

In addition, at least one of methylene groups included in the alkylene group and in the alkyleneoxy group may be replaced by a carbonyl group.

When the divalent organic group has two or more structures represented by the formula (2) and/or when it has two or more structures represented by the formula (3), each of R^{a1} to R^{a2} and R^{b1} to R^{b4} may be same or different.

Examples of the alkyl group having 1 to 4 carbon atoms in the first substituent (R^{a1} to R^{a2}) or the second substituent (R^{b1} to R^{b4}) include: a linear alkyl group such as a methyl group, an ethyl group, an n-propyl group and an n-butyl group; and a branched alkyl group such as an isopropyl group, an isobutyl group and a t-butyl group.

Examples of the linear alkylene group include a linear alkylene group represented by the general formula -CₙH₂ₙ-. In the general formula, n is not particularly limited as long as the molecular weight of the acyclic bifunctional (meth)acrylate monomer is 700 or less, but when the divalent organic group is a single type linear alkylene group, the number of carbon atoms is preferably 3 to 40, and more preferably 4 to 30. At least one of methylene groups included in the linear alkylene group may be replaced by a carbonyl group.

Examples of the linear alkyleneoxy group include a linear alkyleneoxy group represented by the general formula -CₘH₂ₘO-. In the general formula, m is not particularly limited as long as the molecular weight of the acyclic bifunctional (meth)acrylate monomer is 700 or less, but when the divalent organic group is a single type linear alkyleneoxy group, the number of carbon atoms is preferably 2 to 20, and more preferably 2 to 10. At least one of methylene groups included in the linear alkyleneoxy group may be replaced by a carbonyl group.

The divalent organic group includes either the linear alkylene group or the linear alkyleneoxy group, or a combination of a plurality of types thereof; however, it is preferable to consist of either the linear alkylene group or the linear alkyleneoxy group, or a combination of a plurality of types thereof.

Further, each of the linear alkylene group and the linear alkyleneoxy group may have the first substituent and the second substituent.

Examples of the R² include divalent organic groups including the structures indicated below, and it is preferable that the R² consist of one or a combination of two or more of the structures indicated below.

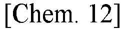

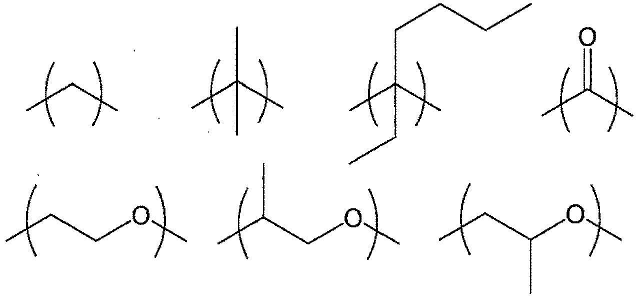

As the above R², -C₄H₈-, -C₆H₁₂-, -C₉H₁₈-, -C₁₀H₂₀-, -(C₂H₄O)₃-, -(C₂H₄O)₄-, - (CH(CH₃)CH₂O)ₘ- (CH₂CH(CH₃)O))ₙ- and the like are preferable. At this time, m + n is preferably 2 to 3.

The acyclic bifunctional (meth)acrylate monomer preferably has a molecular weight of 700 or less, more preferably 540 or less, more preferably 530 or less, and further preferably 450 or less. The molecular weight is preferably 150 or more, more preferably 190 or more.

Specifically, the monomers indicated below are preferably used as the acyclic bifunctional (meth)acrylate monomer. In the following formula, R is a hydrogen atom or a methyl group.

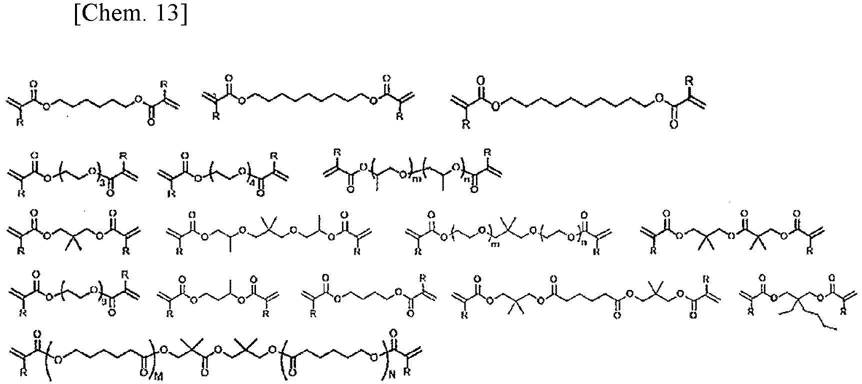

In the monomer represented by the chemical formula, m + n is preferably 2 to 10. In the chemical formula, M + N is preferably 2 to 3.

In the photocurable resin composition for an imprint mold, the compounding amount of the component (b) is preferably 1 to 96 mass% on a major component basis. It is more preferably 10 mass% or more, further preferably 20 mass% or more, and particularly preferably 25 mass% or more. It is more preferably 90 mass% or less, and further preferably 80 mass% or less. By setting the compounding amount within this range, the mold releasability and durability of the resin mold obtained from the photocurable resin composition for an imprint mold can be improved.

The component (b) is desirably an acrylate monomer since it has high photocuring reactivity and a high reaction rate can be obtained. When the reaction rate is high, it tends to be difficult to react with the resin for imprint when used as a resin mold, and good mold releasability tends to be obtained. When the photocuring reactivity is high, the throughput property tends to be superior in mass production of the resin mold. Therefore, the component (b) is preferably an acrylate monomer.

### [Other monomer components]

### (Component (c))

The photocurable resin composition for an imprint mold according to one aspect of the present invention may further include a component (c) other than the component (a) and the component (b) as a monomer component. The molecular weight of the component (c) is preferably 150 to 5000, more preferably 150 to 600, and further preferably 200 to 550. By setting the molecular weight within this range, the mold releasability and durability of the resin mold obtained from the photocurable resin composition for an imprint mold can be improved.

Examples of the component (c) include at least one selected from the group consisting of: an acyclic bifunctional (meth)acrylate monomer having a hydroxyl group and two (meth)acryloyloxy groups (hereinafter, also referred to as "component (c1)"); a urethane-based bifunctional (meth)acrylate monomer having two (meth)acryloyloxy groups (hereinafter, also referred to as "component (c2)"); and a cyclic bifunctional (meth)acrylate monomer having a ring structure and two (meth)acryloyloxy groups (hereinafter also referred to as "component (c3)").

The component (c) is a (meth)acrylate monomer other than the component (a) and the component (b), and is a monomer having neither a fluorine atom nor a siloxane structure.

Further, the component (c1), the component (c2) and the component (c3) are monomers that do not overlap with each other. The component (b), the component (c1), and the component (c3) are monomers having no urethane bond.

### (Component (c1))

The component (c1) is a bifunctional (meth)acrylate monomer having an acyclic structure and a hydroxyl group, and the examples include a monomer represented by the following formula (4). The component (c1) preferably has a molecular weight of 200 to 450. 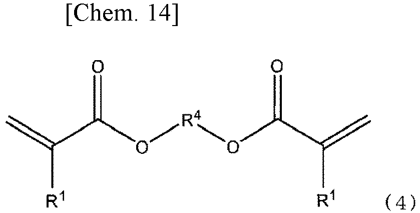 In the general formula (4), R¹ is selected from the same options as R¹ in the general formula (1).

R⁴ is preferably a divalent group including at least one of: a linear alkylene group having at least one hydroxyl group and optionally having a third substituent; and a linear alkyleneoxy group having at least one hydroxyl group and optionally having a fourth substituent. The third substituent and the fourth substituent are preferably selected from the same options as the first substituent.

In addition, as the component (c1), two or more types of bifunctional (meth)acrylate monomers having different structures may be used in combination.

As the component (c1), a monomer in which at least one hydrogen atom of R² in the general formula (1) representing the component (b) is substituted with a hydroxyl group is preferably included. More specifically, the following monomers can be included. In the following formula, R¹ is selected from the same options as R¹ in the general formula (1).

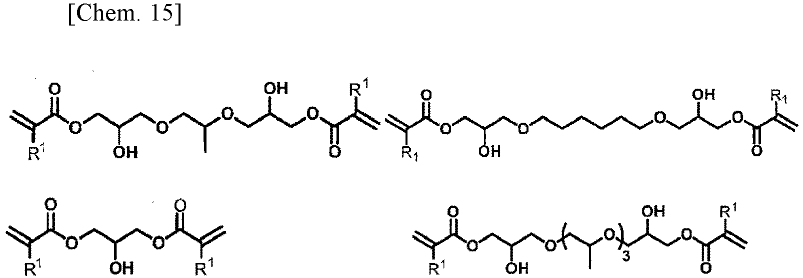

### (Component (c2))

The component (c2) is a urethane-based bifunctional (meth)acrylate monomer having a urethane bond. The component (c2) may be linear or may have a ring structure. Examples of the ring structure include any ring structure selected from an alicyclic ring, a heterocyclic ring, an aromatic ring and a heteroaromatic ring. The component (c2) preferably has a molecular weight of 300 to 600.

As the fluorinated component (c2), two or more types of urethane-based bifunctional (meth)acrylate monomers having different structures may be used in combination.

The details of the ring structure will be described in a section of the component (c3).

### (Component (c3))

The component (c3) is a bifunctional (meth)acrylate monomer having a ring structure. Examples of the ring structure included in the component (c3) include any of a ring structure selected from an alicyclic ring, a heterocyclic ring, an aromatic ring and a heteroaromatic ring. The component (c3) more preferably has a molecular weight of more preferably 400 to 5000, and further preferably 400 to 550.

As the component (c3), two or more types of bifunctional (meth)acrylate monomers having different structures may be used in combination.

Examples of the alicyclic structure include cycloalkane structures having 3 to 10 carbon atoms such as cyclopropane, cyclobutane, cyclopentane, cyclohexane, cycloheptane and cyclooctane. Further, a bicyclic alicyclic structure such as bicycloundecane, decahydronaphthalene, norbornene and norbornadiene; and a tricyclic alicyclic structure such as tricyclodecane and adamantane, and the like may be used. At least a part of carbon-carbon single bonds included in the alicyclic structure may be replaced by a carbon-carbon double bond. The alicyclic structure may have a substituent (hereinafter, also referred to as "fifth substituent").

Examples of the fifth substituent include: linear, branched or cyclic alkyl groups having 1 to 6 carbon atoms; and aryl groups having 12 or less carbon atoms such as phenyl group and naphthyl group.

Examples of the heterocyclic structure include those in which at least one methylene group in the alicyclic structure is replaced by a divalent heteroatom-containing group. Examples of the divalent heteroatom-containing groups include a group selected from the groups consisting of -O-, -CO-, -COO-, -OCO-, -O-CO-O-, - NHCO-, -CONH-, -NH-, -N (R^{SP})-, -S-, -SO-, -SO₂- and the like. The R^{Sp} is preferably selected from the same options as the fifth substituent.

Examples of the aromatic ring include those having 12 or less carbon atoms such as benzene and naphthalene.

Examples of the heteroaromatic ring include those having 12 or less carbon atoms such as furan, thiophene, pyrrole, imidazole, pyridine, pyrimidine and pyrazine.

In the photocurable resin composition for an imprint mold, the compounding amount of the component (c) is preferably 1 to 96 mass% on a major component basis. It is more preferably 5 mass% or more, further preferably 15 mass% or more, and particularly preferably 30 mass% or more. It is more preferably 70 mass% or less, further preferably 60 mass% or less, and particularly preferably 50 mass% or less. By setting the compounding amount within this range, the mold releasability and durability of the resin mold obtained from the photocurable resin composition for an imprint mold can be improved.

In the photocurable resin composition for an imprint mold, the total compounding amount of the component (b) and the component (c) is preferably 30 to 98 mass% on a major component basis. The total compounding amount of the component (b) and the component (c) is more preferably 55 mass% or more, and further preferably 70 mass% or more. The total compounding amount of the component (b) and the component (c) is more preferably 95 mass% or less, and further preferably 85 mass% or less.

In the photocurable resin composition for an imprint mold, the total compounding amount of the component (a), the component (b) and the component (c) is preferably 30 mass% or more on a major component basis, and is preferably 50 mass% or more, further preferably 60 mass% or more, and particularly preferably 80 mass% or more.

The component (c) is desirably an acrylate monomer since it has high photocuring reactivity and a high reaction rate can be obtained. When the reaction rate is high, it tends to be difficult to react with the resin for imprint when used as a resin mold, and good mold releasability tends to be obtained. When the photocuring reactivity is high, the throughput property tends to be superior in mass production of the resin mold. Therefore, the component (c) is preferably an acrylate monomer.

### (Component (d))

The photocurable resin composition for an imprint mold according to one aspect of the present invention may include a monofunctional monomer, a trifunctional or higher polyfunctional (meth)acrylate, and the like as the component (d) other than the components (a) to (c).

Examples of the monofunctional monomer include: a monofunctional (meth)acrylate monomer; a monofunctional (meth)acrylamide monomer; and a monofunctional vinyl monomer.

Examples of the monofunctional (meth)acrylate monomer other than the components (a) to (c) include aliphatic (meth)acrylates such as methyl (meth)acrylate, ethyl (meth)acrylate, propyl (meth)acrylate, n-butyl (meth)acrylate, isobutyl (meth)acrylate, tert-butyl (meth)acrylate, 2-ethylhexyl (meth)acrylate, cyclohexyl (meth)acrylate, dicyclopentenyl (meth)acrylate, dicyclopentenyloxyethyl (meth)acrylate, dicyclopentanyl (meth)acrylate, isobornyl (meth)acrylate, adamantyl (meth)acrylate and tetrahydrofurfuryl (meth)acrylate; (meth)acrylates having an aromatic ring such as benzyl (meth)acrylate, phenoxymethyl (meth)acrylate, phenoxyethyl (meth)acrylate, phenoxyethylene glycol-modified (meth)acrylate and hydroxyphenoxyethyl (meth)acrylate.

Examples of the monofunctional (meth)acrylamide monomer include dimethyl(meth)acrylamide, (meth)acryloylmorpholine, hydroxyethyl(meth)acrylamide, isopropyl(meth)acrylamide, diethyl(meth)acrylamide, dimethylaminopropyl(meth)acrylamide, dimethylaminopropyl(meth)acrylamide methyl chloride quaternary salt, and diacetone (meth)acrylamide.

Examples of the monofunctional vinyl monomer include styrene, N-vinyl-2-pyrrolidone, N-vinylcaprolactam, N-methyl-N-vinylacetamide, and N-vinylformamide.

The monofunctional monomer preferably has neither a fluorine atom nor a siloxane structure.

The compounding amount of the monofunctional monomer is preferably 50 mass% or less, more preferably 40 mass% or less, and further preferably 10 mass% or less on a major component basis in the photocurable resin composition for an imprint mold. The compounding amount of this monofunctional monomer is 50 mass% or less, more preferably 40 mass% or less, further preferably 10 mass% or less including not only the component (d) but also the monofunctional monomers of all the components (components (a) to component (d), etc.) included in the composition.

By setting the compounding amount within this range, the durability of the resin mold obtained from the photocurable resin composition for an imprint mold can be improved.

The trifunctional or higher polyfunctional (meth)acrylate monomer other than the components (a) to (c) as the component (d) is not particularly limited.

Examples of the trifunctional or higher polyfunctional (meth)acrylate monomer as the component (d) include trimethylolpropane tri(meth)acrylate, ethoxylated trimethylolpropane tri(meth)acrylate, propoxylated trimethylolpropane tri(meth)acrylate, pentaerythritol tri(meth)acrylate, pentaerythritol tetra(meth)acrylate, ditrimethylolpropane tetra(meth)acrylate and dipentaerythritol poly(meth)acrylate.

The compounding amount of the trifunctional or higher polyfunctional (meth)acrylate monomer is preferably less than 50 mass%, and preferably 30 mass% or less, on a major component basis in the photocurable resin composition for an imprint mold. By setting the compounding amount within this range, the good releasability of the resin mold obtained from the photocurable resin composition for an imprint mold can be obtained.

### [Photopolymerization initiator and other components]

### (Photopolymerization initiator)

The photocurable resin composition for an imprint mold according to one aspect of the present invention may contain a photopolymerization initiator, an additive and the like in addition to the monomer components.

As the photopolymerization initiator, α-hydroxyalkylphenone-based or acylphosphine oxide-based ones are preferable. Examples of the α-hydroxyalkylphenone-based photopolymerization initiator include Omnirad 184, Omnirad 1173, Omnirad 127, and Omnirad 2959, manufactured by IGM, and ESACURE ONE, ESACURE KIP150, ESACURE KIP75LT, ESACURE KIP IT, and ESACURE KIP100F, manufactured by Lamberti. Examples of the acylphosphine oxide-based photopolymerization initiator include Omnirad 819, Omnirad TPO, and Omnirad 1800, manufactured by BASF. The photopolymerization initiator may be used alone or in combination of a plurality of types.

The photopolymerization initiator is preferably contained in the photocurable resin composition for an imprint mold at 0.01 to 20 mass% on a major component basis. The amount is more preferably 0.1 mass% or more, and further preferably 1 mass% or more, on a major component basis in the photocurable resin composition for an imprint mold. Further, it is more preferably 15 mass% or less.

### (Other components)

The photocurable resin composition for an imprint mold according to one aspect of the present invention may include a solvent.

The solvent may be one usually used in a photocurable resin composition for an imprint mold, and examples thereof include MEK, MIBK, propylene glycol monomethyl ether acetate, propylene glycol monomethyl ether, diethylene glycol dimethyl ether, and ethyl lactate.

In addition, the above-mentioned "on a major component basis" is calculated by using the components of the composition excluding the solvent as the "major component". The monomer components, photopolymerization initiators, additives described below, and the like are the major components. When the photocurable resin composition for an imprint mold includes a solvent, 1 to 10000 parts by mass of the solvent can be used with respect to 100 parts by mass of the major component.

The photocurable resin composition for an imprint mold according to one aspect of the present invention may include an additive.

Examples of the additive include mold release agents, silane coupling agents, UV absorbers, antioxidants, light stabilizers, plasticizers, adhesion promoters, thermal polymerization initiators, colorants, fine particles, photoacid generators, photobase generators, surfactants, antifoaming agents and dispersants. For these, those usually used for a photocurable resin composition for an imprint mold can be used. The additive in the photocurable resin composition for an imprint mold can be optionally compounded, and when the additive is compounded, the content is preferably 10 mass% or less on a major component basis.

The thermal polymerization initiator may be included, but when the curing by the photopolymerization initiator is sufficient, it may not be positively included.

### <2> Preparation of photocurable resin composition for an imprint mold

The composition according to some aspects of the present invention can be prepared by compounding and mixing each of the monomer components, the photopolymerization initiator, and if necessary, other additives.

The photocurable resin composition for an imprint mold is preferably prepared so that the viscosity is as follows. That is, when a resin mold is manufactured using the photocurable resin composition for an imprint mold, the photocurable resin composition for an imprint mold is preferably prepared so as to have a viscosity such that air bubbles do not get caught in the concave-convex pattern of the master mold and the pattern is quickly filled.

### <3> Resin mold

Another aspect of the present invention is a resin mold obtained by curing the photocurable resin composition for an imprint mold so as to have a plurality of concave-convex patterns.

The resin mold can be obtained by a usual method for manufacturing a resin mold. Specifically, the resin mold according to one aspect of the present invention can be prepared by the manufacturing method including: a step of forming a composition layer of a photocurable resin composition for an imprint mold; a step of contacting a mold tool for a resin mold (hereinafter, also referred to as "master mold") with a surface of the composition layer; a step of irradiating the composition layer with light to obtain a photocured product having a concave-convex pattern; and a step of releasing the mold tool from the photocured product to obtain the resin mold.

The conditions for irradiation of light are preferably conditions so that the reaction rate of the composition of the composition layer is 80% or more from the viewpoint of durability. The reaction rate can be measured by using IR based on the peak of the (meth)acryloyl group. Since the conditions under which the reaction rate is 80% or more vary depending on the compounding ratio of each component in the composition and the like, it is preferable to predetermine the above conditions in advance by curing the composition to be used beforehand.

The details will be described later.

The resin mold according to one aspect of the present invention has good durability and are superior in mold releasability with respect to the transfer layer by using the specific composition.

An example of the method for manufacturing a resin mold according to one aspect of the present invention is indicated below.

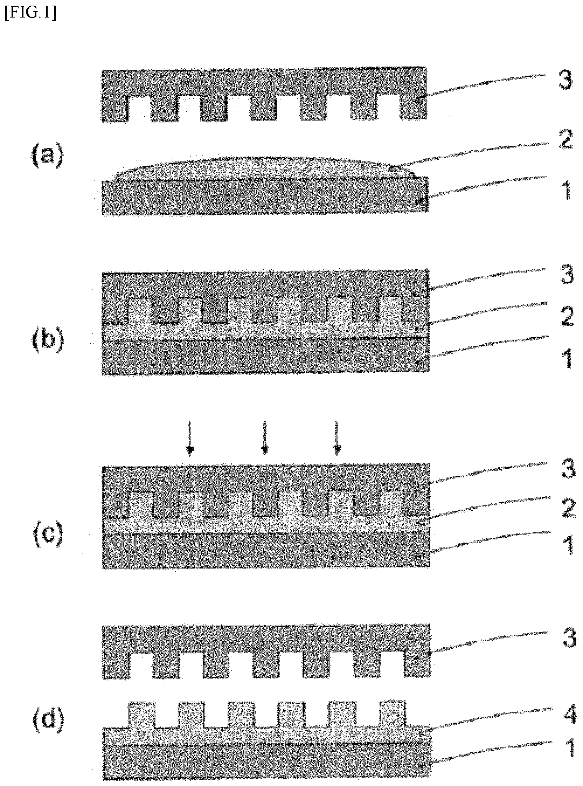

Specifically, as indicated in FIG. 1(a), first, a transparent substrate 1 and a master mold 3 on which a concave-convex pattern is formed are prepared, and a photocurable resin composition 2 for an imprint mold according to one aspect of the present invention is provided on the substrate 1 to form a resin composition layer. Next, as indicated in FIG. 1(b), the substrate 1 and the master mold 3 are contacted with the composition 2, and the concave portions of the concave-convex pattern of the master mold 3 are filled with the composition 2 (filling step). Although FIG. 1 illustrates the composition 2 provided on the substrate 1, the composition 2 may be provided on the master mold 3.

The substrate 1 is appropriately selected. For example, when the photocurable resin composition for an imprint mold according to one aspect of the present invention is sandwiched between the master mold 3 and the substrate 1, and the composition is cured by light irradiation, a light-transmissive substrate is suitable.

Example thereof include: transparent inorganic substrates such as glass, quartz and sapphire; ceramic substrates; synthetic resin substrates such as polycarbonate, PET (polyethylene terephthalate) and triacetylcellulose. The surface of the substrate 1 may be pretreated in order to adjust the affinity with the composition 2. Specific examples of the pretreatment include wet surface cleaning; surface modification by plasma, ozone cleaning, etc.; and surface treatment such as a silane coupling agent.

The method for providing the composition 2 on the substrate 1 or the master mold 3 is not particularly limited, and examples thereof include application and dropping of the composition diluted with a solvent or the like, if necessary. Specific examples thereof include spin coating, roll coating, dip coating, gravure coating, die coating, curtain coating, inkjet application and dispenser application.

The composition 2 may be provided so as to cover the entire surface of the master mold 3 or the substrate 1, but it may also be provided on a part of them.

The master mold 3 having a desired pattern such as a concave-convex pattern formed on the surface is used. Examples of the material of the mold 3 include quartz glass and synthetic resins such as PDMS (polydimethylsiloxane), as well as inorganic compounds such as silicon, silicon carbide, silicon oxide and nickel. The appearance of the master mold 3 may be similar to the appearance of the mold used in the usual photoimprint method, and the appearance may be, for example, a rectangular parallelepiped shape or a roll shape.

Further, in order to improve the mold releasability, the surface of the master mold 3 may be subjected to a treatment for improving the mold releasability (mold release treatment). The mold release treatment can be carried out by a vapor phase method, a liquid phase method, or the like using a known mold release treatment agent, exemplified by: a perfluoro-based or hydrocarbon-based polymer compound; an alkoxysilane compound; a trichlorosilane compound; a diamond-like carbon; or the like. Examples of commercially available fluorinated mold release treatment agents include "Optool" manufactured by Daikin Industries, Ltd. (for example, Optool DSX, HD1100Z, HD2100Z, and HD1100TH).

Further, the concave-convex pattern formed on the surface of the master mold 3 is appropriately selected. For example, it may be same as the concave-convex pattern formed on the surface of the mold used in the usual photoimprint method. For example, a concave portion may be formed by forming a recess on the surface of the material of the master mold 3, and in this case, a portion relatively protruding toward the surface side becomes a convex portion. Further, a convex portion may be formed by providing a protrusion on the surface of the material of the master mold 3, and in this case, the portion recessed relatively inward becomes the concave portion. Further, a master plate having a concave-convex pattern formed by providing recesses or protrusions on the surface of the material of the master plate may be used, and a mold formed by using this master plate as a mold may be used as the master mold 3. The shape of the cross section of each concave portion of the concave-convex pattern may be, for example, a square, a rectangle, a triangle, a circle, a semicircle, or a shape similar to those shapes. Each concave portion may have, for example, a depth of about 0.00001 to 3 mm and an opening diameter of about 0.00001 to 5 mm.

In this way, after providing the composition 2 on the substrate 1 or the master mold 3, the substrate 1 and the master mold 3 are opposed to each other, and as indicated in FIG. 1(b), the composition 2 and the surface of the master mold 3 on which the concave-convex pattern is formed are contacted with each other, and the concave portion of the concave-convex pattern of the master mold 3 are filled with the composition. When the concave portion of the concave-convex pattern are filled with the composition 2, a force of about 0.01 to 10 MPa may be applied, if necessary. In the filling step, an apparatus in the conventional photoimprint method can be used.

Next, as indicated in FIG. 1(c), the composition 2 and the master mold 3 are contacted with each other and the composition 2 is irradiated with light to be cured in a state where the concave portion of the concave-convex pattern of the master mold 3 are filled with the composition 2 to obtain a resin mold 4, which is a photocured product (photocuring step).

The light source used for light irradiation may be any that can radiate light having a wavelength at which the composition is cured, for example, light having a wavelength of 200 to 500 nm; however, a wavelength of the light is preferably one that transmits at least a part of the substrate 1 or the master mold 3. Examples of the light source include low-pressure mercury lamps, high-pressure mercury lamps, ultrahigh-pressure mercury lamps, metal halide lamps, xenon lamps, carbon arcs, mercury xenon lamps, excimer lasers such as XeCl or KrF, ultraviolet or visible light lasers, and ultraviolet or visible light LEDs.

The amount of light irradiation may be any amount as long as the composition can be cured. When the present invention is carried out, it is typically preferable to select the irradiation amount in the range of 0.1 to 500 J/cm², and it is appropriately selected depending on the composition and/or the desired thickness of the resin layer, and the like. The composition 2 is irradiated with light from a side of the member whichever of the substrate 1 and the master mold 3 is substantially transparent to the light to be radiated.

Next, as indicated in FIG. 1(d), the master mold 3 is released from the resin mold 4 of one aspect of the present invention, and if necessary, the resin mold 4 is peeled off from the substrate 1 to form the resin mold 4 in which the concave-convex pattern of the master mold 3 is inverted and transferred.

The method for using the obtained resin mold 4 is appropriately selected. For example, in the photo-nanoimprint method, it can be used in a method for manufacturing a resin by using the above resin mold and a precursor of a photocurable resin for pattern formation.

### <4> Pattern forming method

Another aspect of the present invention is a pattern forming method, including: a step of forming a transfer layer on a base material using a photocurable resin composition for imprint transfer; a step of contacting the resin mold with a surface of the transfer layer; and a step of irradiating the transfer layer with light to form a concave-convex pattern.

The pattern can be formed in the same manner as a usual imprint method except that the resin mold according to one aspect of the present invention is used.

As the photocurable resin composition for imprint transfer, a usual one can be used.

An example of the pattern forming method of one aspect of the present invention is indicated below.

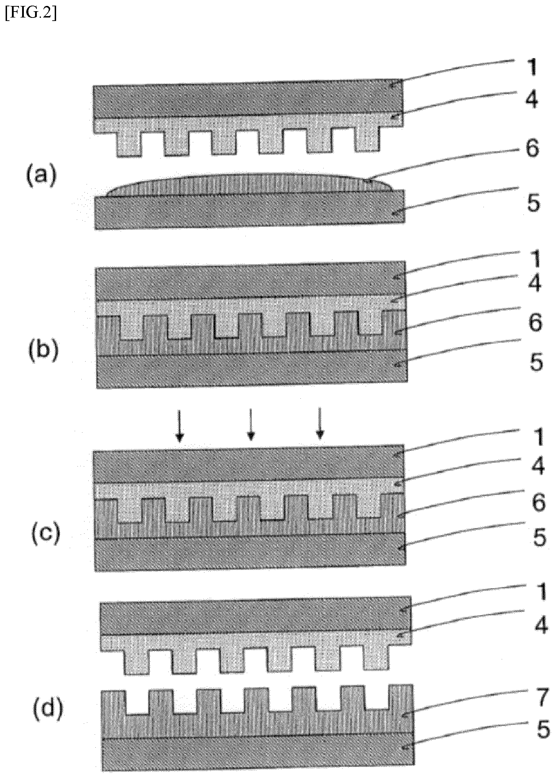

Specifically, as indicated in FIG. 2(a), first, a substrate 5 and the resin mold 4 according to one aspect of the present invention on which a concave-convex pattern is formed are prepared, and a photocurable resin composition 6 for an imprint mold is provided on the substrate 5 to form a transfer layer. Next, as illustrated in FIG. 2(b), the composition 6 is sandwiched between the substrate 5 and the resin mold 4, and the concave portions of the concave-convex pattern of the resin mold 4 are filled with the composition 6 (filling step). Although in FIG. 2(b), the composition 6 provided on the substrate 5 is illustrated, the composition 6 may be provided on the resin mold 4.

The substrate 5 may be any substrate on which the composition 6 can be provided, and may be, for example, a substrate used in a usual photoimprint method. Specific examples include semiconductor substrates such as silicon wafers; compound semiconductor substrates such as GaAs, InAs, and GaN; transparent inorganic substrates such as glass, quartz, and sapphire; ceramic substrates; synthetic resin substrates such as polycarbonate, PET (polyethylene terephthalate), and triacetylcellulose; metal substrate; or metal oxide substrate. Examples of the transparent substrate 5 include a glass substrate, a quartz substrate, a sapphire substrate, a transparent synthetic resin substrate. The surface of the substrate 5 may be pretreated in order to adjust the affinity with the composition 6. Specific examples of the pretreatment include wet surface cleaning; surface modification by plasma, ozone cleaning, and the like; treatment with an adhesiveness improver such as a silane coupling agent.

The method for providing the composition 6 on the substrate 5 or the resin mold 4 is not particularly limited, and examples thereof include application and dropping of the composition 6 diluted with a solvent or the like, if necessary. Specific examples thereof include spin coating, roll coating, dip coating, gravure coating, die coating, curtain coating, inkjet application and dispenser application.

The composition 6 may be provided so as to cover the entire surface of the rein mold 4 or the substrate 5, but it may also be provided on a part of them.

The appearance of the resin mold 4 may be similar to the appearance of the master 3 mold used in the usual photoimprint method, and the appearance may be, for example, a rectangular parallelepiped shape or a roll shape. Further, as the concave-convex pattern formed on the surface of the resin mold 4, the inverted concave-convex pattern of the master mold 3 is formed.

In this way, after the composition 6 is provided on the substrate 5 or the resin mold 4, the substrate 5 and the resin mold 4 are opposed to each other, and as indicated in FIG. 2(b), the composition 6 and the surface of the resin mold 4 on which the concave-convex pattern is formed are contacted with each other, and the concave portion of the concave-convex pattern of the resin mold 4 are filled with the resin composition 6. At the time of this filling, if necessary, a force of about 0.01 to 10 MPa may be applied. In the filling step, an imprint apparatus in the conventional photoimprint method can be used.

Next, as indicated in FIG. 2(c), the composition 6 is contacted with the resin mold 4, and the composition 6 is cured by light irradiation in a state where the concave portions of the concave-convex pattern of the resin mold 4 are filled with the composition 6 to form a photocured layer 7 (Photocuring step).

Examples of the light source used for light irradiation include same as those used in the photocuring step when the resin mold 4 is produced. The amount of light irradiation may be any amount as long as the composition 6 can be cured. When the present invention is carried out, the irradiation amount is typically selected within a range of 0. 1 to 10 J/cm², although it depends on the composition of the composition 6 to be cured, the thickness of the layer, or the like. The composition 6 is irradiated with light from a side of the member whichever of the substrate 5 and the resin mold 4 is substantially transparent to the light to be radiated.

Next, as indicated in FIG. 2(d), the resin mold 4 is released from the photocured layer 7, and the photocured layer 7 is peeled off from the substrate 5, if necessary, to form the photocured layer 7 on which the concave-convex pattern of the resin mold 4 is transferred.

The photocured layer having the pattern obtained by the pattern forming method of some aspects of the present invention can be used as an optical member as described later.

Further, the photocured layer having the pattern obtained by the pattern forming method of some aspects of the present invention may be used as an etching resist.

### <5> Composite

One aspect of the present invention is a composite having: the above-described resin mold; and a photocured layer formed by radiating light in a state where the resin mold is contacted with the transfer layer formed by using a photocurable resin composition for an imprint transfer.

The composite can be obtained by the same manufacturing method as a usual imprint method except that the resin mold according to one aspect of the present invention is used.

As the photocurable resin composition for an imprint transfer, a usual one can be used.

Since the resin mold according to one aspect of the present invention is superior in mold releasability and durability and is low in cost, it can also be used as a protective member for the member obtained by the pattern forming method. That is, by not peeling off the photocured layer and the resin mold immediately after the photocuring step, the resin mold functions as a protective member for protecting the concave-convex structure of the photocured layer. Later, the protective member-cum-resin mold can be peeled off from the photocured layer.

As described above, by using the resin mold after the photocuring step as a protective member, it can prevent the concave-convex structure from being damaged during transportation and a foreign matter from being mixed into the concave-convex structure.

Even when the composition is other than the resin composition for an imprint mold used in the Examples described later, the composition containing the components (a) and (b) contained at the specific ratio tends to yield the resin mold being superior in long-term mold releasability and being useful as the protective member-cum-resin mold.

### <6> Method for manufacturing composite

One aspect of the present invention is a method for manufacturing a composite, the method including: a step of forming a transfer layer on a base material using a photocurable resin composition for an imprint transfer; a step of contacting the resin mold with a surface of the transfer layer; and a step of obtaining a composite having the resin mold and a photocured layer by irradiating the transfer layer with light to form the photocured layer having a concave-convex pattern.

### <7> Method for manufacturing an optical member

One aspect of the present invention is a method for manufacturing an optical member by using the above-mentioned pattern forming method to manufacture an optical member.

Except that the resin mold according to one aspect of the present invention is used, the optical member is manufactured by a usual imprint pattern forming method. Specifically, the method for manufacturing an optical member according to one aspect of the present invention is a method for manufacturing an optical member having a cured layer having a concave-convex structure, the method including: a step of forming a composition layer on a base material using the photocurable resin composition for an imprint transfer; a step of pressing the resin mold against a surface of the composition layer and transferring the concave-convex structure to the composition layer to form a pattern-formed layer; and a step of forming a cured layer having a concave-convex structure by photocuring the pattern-formed layer.

In some aspects of the present invention, the pattern of the optical member is a pattern sized from a few nm to a few mm. The method for manufacturing an optical member according to one aspect of the present invention can be applied to pattern transfer such as nano-order, micro-order and milli-order patterns, and is particularly effective for fine pattern transfer for nano-order and micro-order.

In the present invention, "light" includes not only lights and electromagnetic waves having wavelengths in the ultraviolet, near-ultraviolet, far-ultraviolet, visible, and infrared regions, but also radiation.

The optical member manufactured by the above-described method can be used for a camera lens such as a condenser lens, a light guide plate, an antireflection film, a film for an optical waveguide, glasses and the like.

### Examples

Hereinafter, some aspects of the present invention will be described based on Examples, but the present invention is not limited to these Examples.

### (Component (a))

The following were prepared as the component (a).

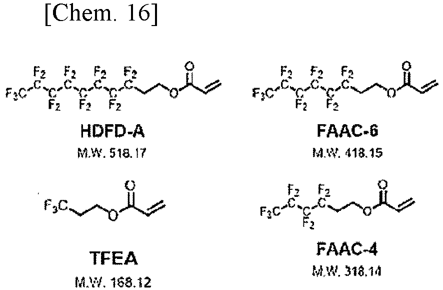

Details of the component (a) used in Examples and Comparative Examples are indicated below.
HDFD-A (manufactured by Tokyo Chemical Industry Co., Ltd., fluorine content: 62.3 mass%)
FAAC-6 (manufactured by Unimatec Co., Ltd., fluorine content: 59.1 mass%)
FAAC-4 (manufactured by Unimatec Co., Ltd., fluorine content: 53.7 mass%)
TFEA (manufactured by Tokyo Chemical Industry Co., Ltd., fluorine content: 33.9 mass%)

### (Component (b))

The following were prepared as the component (b).

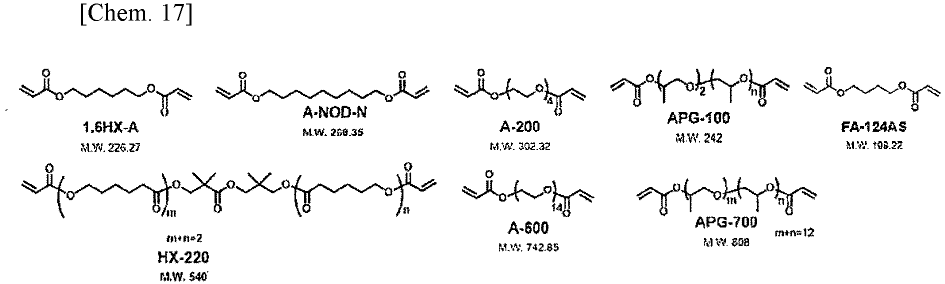

Details of the component (b) used in Examples and Comparative Examples are indicated below.
1.6HX-A (manufactured by Kyoeisha Chemical Co., Ltd.)
A-NOD-N (manufactured by Shin Nakamura Chemical Industry Co., Ltd.)
A-200 (manufactured by Shin Nakamura Chemical Industry Co., Ltd.)
APG-100 (manufactured by Shin Nakamura Chemical Industry Co., Ltd.)
FA-124AS (manufactured by Hitachi Chemical Co., Ltd.)
HX-220 (manufactured by Nippon Kayaku Co., Ltd.)
A-600 (manufactured by Shin Nakamura Chemical Industry Co., Ltd.)
APG-700 (manufactured by Shin Nakamura Chemical Industry Co., Ltd.)

### (Component (c))

The following were prepared as the component (c).

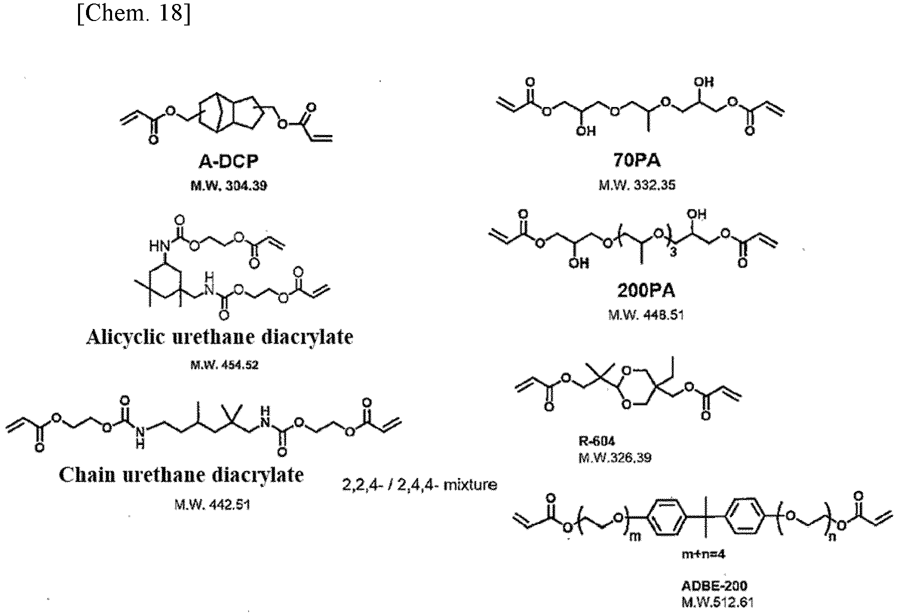

Details of the component (c) used in Examples and Comparative Examples are indicated below.
A-DCP (manufactured by Shin Nakamura Chemical Industry Co., Ltd.)
70PA (manufactured by Kyoeisha Chemical Co., Ltd.)
200PA (manufactured by Kyoeisha Chemical Co., Ltd.)
ADBE-200 (manufactured by NOF CORPORATION)
R-604 (manufactured by Nippon Kayaku Co., Ltd.)

The alicyclic urethane diacrylate as indicated above was synthesized as follows.

Into a three-necked flask equipped with a water-cooled condenser, 9.78 g (0.044 mol) of isophorone diisocyanate (manufactured by Tokyo Chemical Industry Co., Ltd.), 10.3 g (0.089 mol) of 2-hydroxyethyl acrylate (manufactured by Tokyo Chemical Industry Co., Ltd.) and 5 mg of dibutyltin dilaurate as a catalyst were added, and the mixture was stirred at 80°C for 5 hours. Then, it was left to room temperature to obtain the alicyclic urethane diacrylate.

The chain urethane diacrylate as indicated above was synthesized as follows.

Into a three-necked flask equipped with a water-cooled condenser, 9.50 g (0.045 mol) of trimethylhexamethylene diisocyanate (manufactured by Tokyo Chemical Industry Co., Ltd.), 10.6 g (0.091 mol) of 2-hydroxyethyl acrylate (manufactured by Tokyo Chemical Industry Co., Ltd.) and 5 mg of dibutyltin dilaurate as a catalyst were added, and the mixture was stirred at 80 °C for 3 hours. Then, it was left to room temperature to obtain the chain urethane diacrylate.

Details of the component (d) used in the Examples are indicated below.
CHA: Cyclohexyl acrylate (manufactured by Osaka Organic Chemical Industry Co., Ltd.)
TMPTA: Trimethylolpropane triacrylate (manufactured by Osaka Organic Chemical Industry Co., Ltd.)

### <Preparation of photocurable resin composition sample for an imprint mold>

Photocurable resin composition samples for an imprint mold (Examples 1 to 43 and Comparative Examples 1 to 4) were prepared by stirring and mixing each component at room temperature with the composition and compounding amount (parts by mass) indicated in Tables 1 to 8.

The details of the photopolymerization initiator in Tables are as follows. Omnirad 1173 (manufactured by IGM Resins B.V.)

### <Appearance evaluation of photocurable resin composition for an imprint mold>

First, the appearances of the prepared and obtained resin compositions for an imprint mold (Examples 1 to 43 and Comparative Examples 1 to 4) were visually observed and evaluated according to the following criteria.
Good (A); The composition is transparent and no phase separation is observed.
No good (NG); The composition is opaque or phase separation is observed.

In addition, on a resin composition for an imprint mold evaluated as NG, it was judged to be unable to produce the resin mold, and the reaction rate of the resin mold, the mold releasability evaluation of the resin mold, and the transfer durability evaluation of the resin mold were not performed. The results are indicated in Tables 1 to 8.

### <Production of a resin mold>

Each of the above photocurable resin compositions for an imprint mold was dropped on a 100 µm-thick adhesive-treated PET film (Cosmo Shine A4100, manufactured by Toyobo Co., Ltd.) with a dropper, and uniformly applied by using a bar coater with a film thickness of about 10 µm.

Next, the PET film coated with the photocurable resin compositions for an imprint mold was pressed against a nickel mold (length 50 mm, width 50 mm, thickness 1 mm) having a fine concave-convex pattern, which was mold-release treated with a commercially available fluorinated mold release treatment agent (Optool HD2101Z, manufactured by Daikin Industries, Ltd.).

In this state, the composition was photocured by radiating light from the PET film side by using an LED light source having a wavelength of 365 nm under a nitrogen atmosphere. The irradiation amount was 1500 mJ/cm². After the photo-curing, the nickel mold was released to obtain a resin mold having a fine concave-convex pattern.

### <Evaluation of resin mold releasability>

A photocurable resin composition for imprint transfer was added dropwise to the resin molds produced as above (Examples 1 to 43 and Comparative Examples 1 to 4). Next, the PET film was placed on the photocurable resin composition for imprint transfer, and the photocurable resin composition for imprint transfer was sandwiched between the PET film and the resin mold. The photocurable resin composition for imprint transfer was cured by radiating light from the PET film surface side with an LED light source under the condition of 1 J/cm² to form a photocured layer. Then, the photocured layer was peeled off from the resin mold. The degree of force applied at this time, that is, the mold releasability was judged by hand, and the mold releasability of the resin mold was evaluated as follows.
AAA (Extremely good mold release); The mold can be easily released with very little force, and pattern transfer is possible.
AA (Very good mold release); The mold can be easily released with little force, and pattern transfer is possible.
A (Good mold releasability); Pattern transfer is possible with a little force.
NG (Poor mold releasability); Defects are observed in some or all areas, and pattern transfer is impossible.

In addition, the mold releasability after 168 hours or longer under the condition of 25°C after the photocuring (long-term mold releasability) was also evaluated in the same manner. The evaluation criteria at that time are the same as above.

### <Evaluation of transfer durability of a resin mold>

A series of operations consisting of dropping the resin composition for imprint transfer, light irradiation, and peeling off (durability test) was repeated, and whether obvious roughness that was visually discriminable was observed on the surface of the resin mold. From the results, the transfer durability of each resin mold (Examples 1 to 43 and Comparative Examples 1 to 4) was evaluated as follows.

It should be noted that the obvious roughness of the surface of the resin mold is due to the decrease in the mold releasability of the resin mold caused by the deterioration of the surface of the resin mold and the like. When the surface of the resin mold is obviously roughened, the surface of the obtained photocured layer is obviously roughened.
AA (Good); There was virtually no or little roughness on the surface of the resin mold after 200 durability tests.
A (Slightly good); Obvious roughness occurred on the surface of the resin mold after 51 to 200 durability tests.
NG (Poor); Obvious roughness occurred on the surface of the resin mold after 10 to 50 durability tests.

In the above result, "NG (Poor)" is an evaluation when the durability of the resin mold is evaluated according to the above criteria, and does not mean that it cannot be used in all cases. That is, a resin composition even judged as "NG (Poor)" can be used as a resin mold forming material depending on a required number of transfers and fineness. Of course, it does not prevent the composition from being used as a composition for forming a layer to be transferred other than the resin mold.

### <Reaction rate of a resin mold>

The photocurable composition for an imprint mold before curing and the resin mold after curing were measured by the ATR method of FT-IR. From this measurement, a reduction rate of the peak near 810 cm⁻¹ derived from the carbon-carbon double bond included in the (meth)acryloyl group before and after the photocuring was calculated to derive the reaction rate. During that time, the peak near 1720 cm⁻¹ derived from the carbonyl group included in the (meth)acryloyl group was used as a reference. The reaction rate was evaluated based on the following criteria.
A (Good); Reaction rate is 80% or more
NG (Poor); Reaction rate is less than 80%

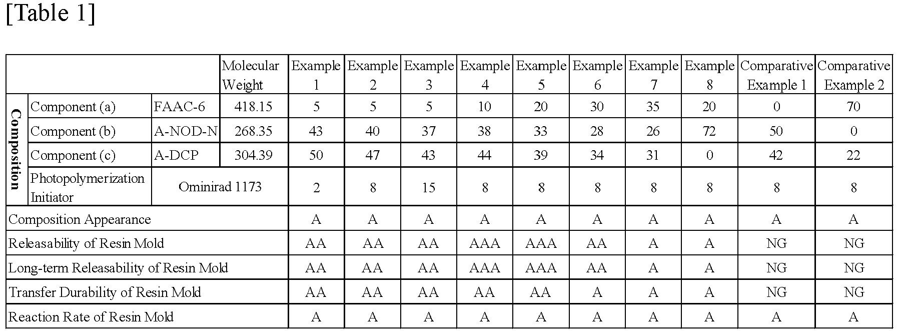

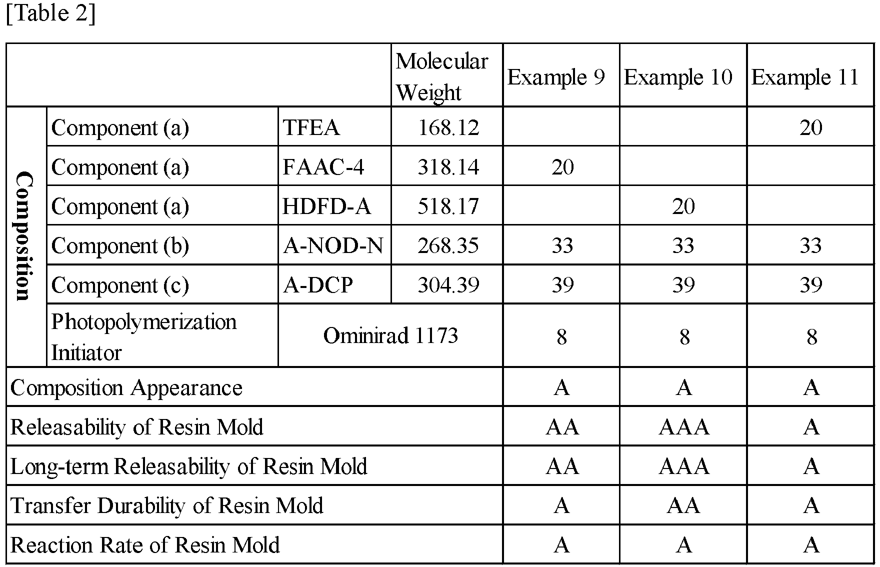

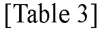

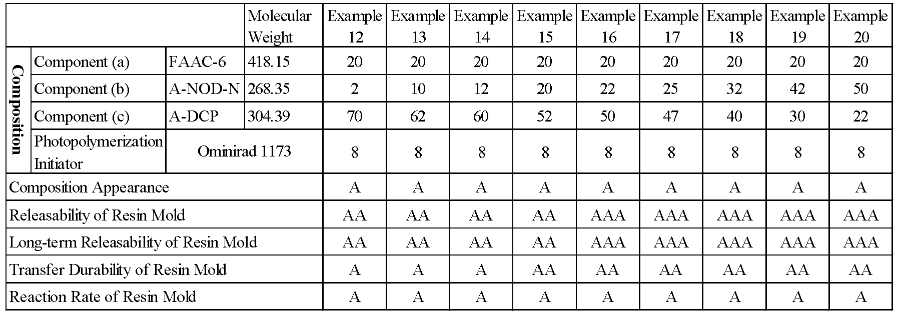

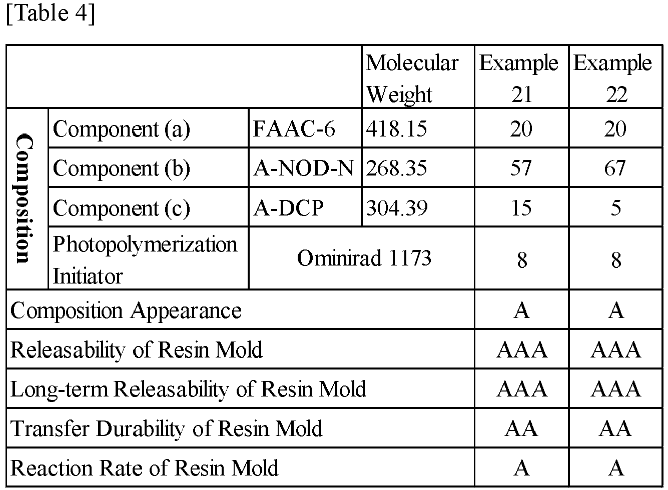

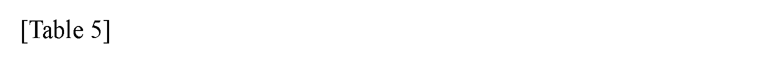

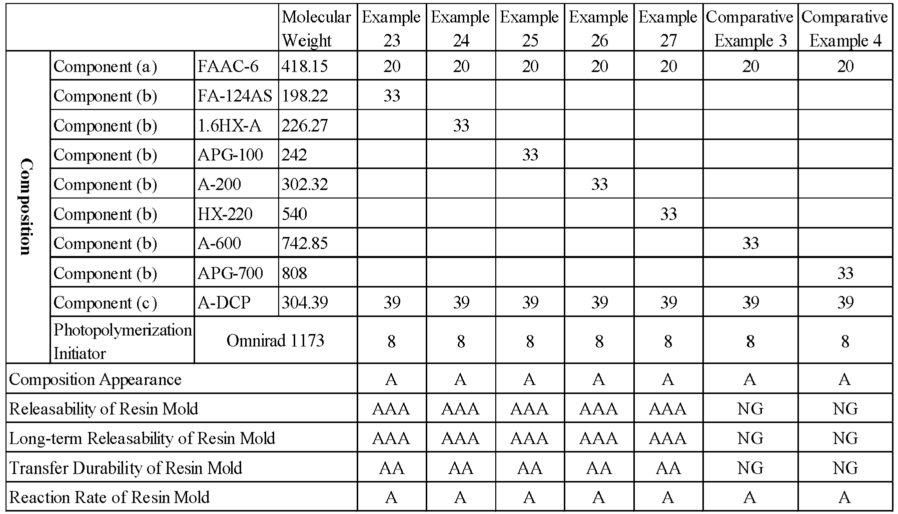

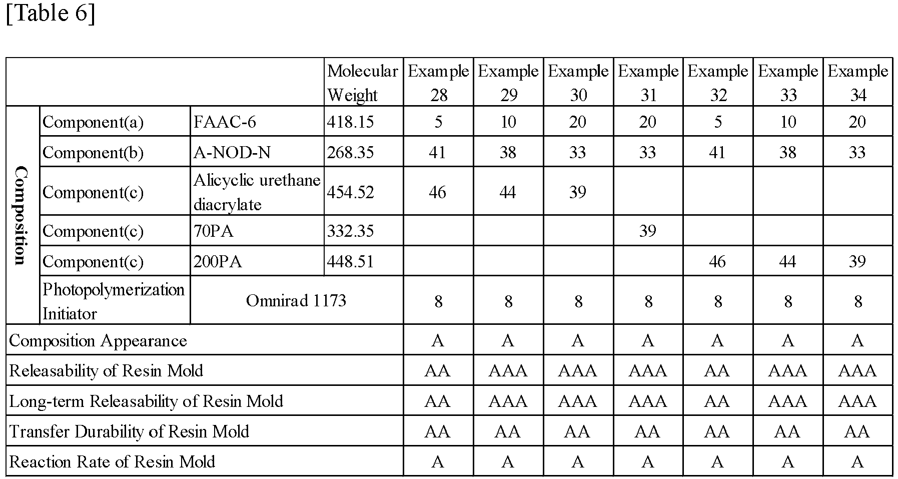

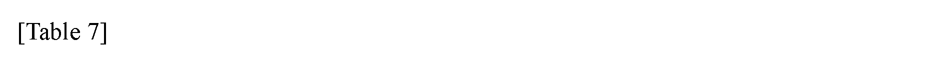

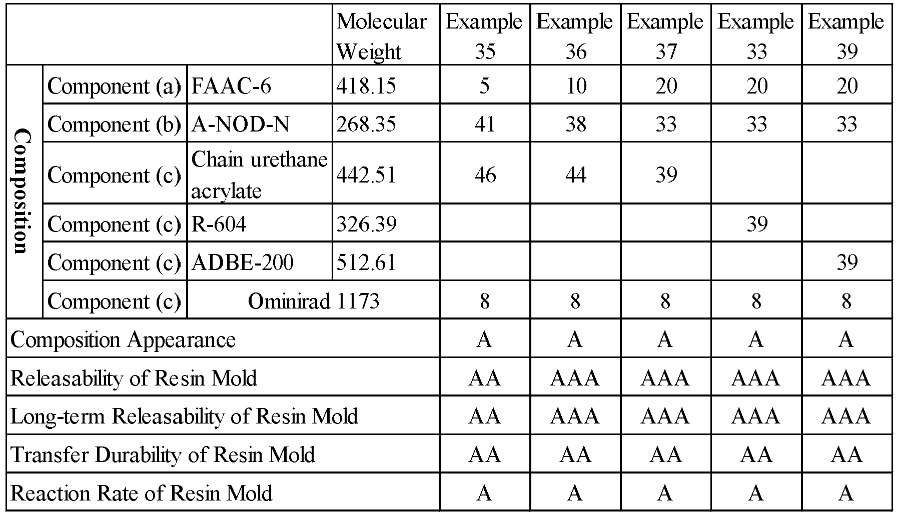

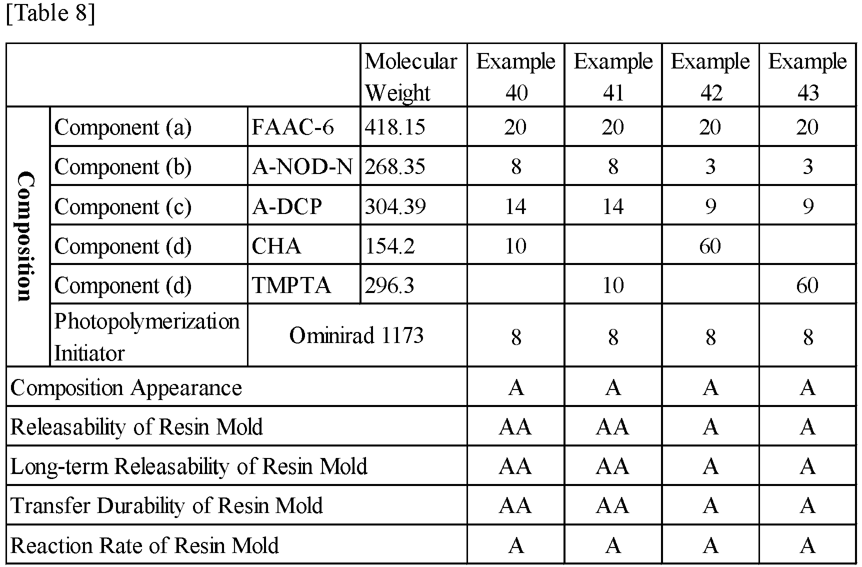

As indicated in Tables, the resin mold obtained from the photocurable resin composition for an imprint mold according to some aspects of the present invention is superior in mold releasability, long-term mold releasability and durability. On the other hand, it is found that the resin mold obtained from the photocurable resin composition for an imprint mold of Comparative Examples is inferior in mold releasability, long-term mold releasability and durability.

### [Industrial applicability]

According to the present invention, a resin mold having mold releasability and durability can be obtained, and a low-cost photocurable resin composition for an imprint mold can be provided.

### Explanation of References

1 Substrate
2 Photocurable resin composition for an imprint mold
3 Master mold
4 Resin mold
5 Substrate
6 Photocurable resin composition for imprint transfer
7 Photocured layer

## Claims

1. A photocurable resin composition for an imprint mold, the composition comprising:
a component (a): at least one of: a fluorinated (meth)acrylate monomer having at least one (meth)acryloyloxy group; and a dialkylsiloxane-based (meth)acrylate monomer having at least one (meth)acryloyloxy group; and
a component (b): an acyclic bifunctional (meth)acrylate monomer having two (meth)acryloyloxy groups represented by the following formula (1),
wherein a compounding ratio between the component (a) and the component (b) is 1 to 97 : 99 to 3 in terms of mass ratio, and
the component (b) has a molecular weight of 700 or less, 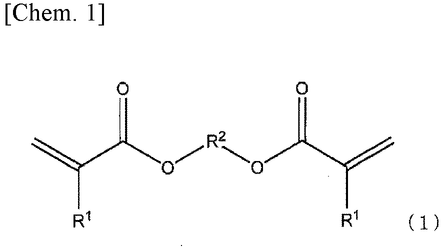
wherein in the general formula (1), each R¹ is independently a hydrogen atom or a methyl group,
R² is a divalent organic group having no ring structure, and
the divalent organic group having no ring structure contains at least one of: a linear alkylene group which may have a substituent; and a linear alkyleneoxy group which may have a substituent, the substituent has 1 to 4 carbon atoms, and at least one of methylene groups included in the alkylene group and in the alkyleneoxy group may be replaced by a carbonyl group.

2. The photocurable resin composition for an imprint mold according to claim 1, wherein the divalent organic group having no ring structure comprises at least one of: a linear alkylene group which may have a substituent; and a linear alkyleneoxy group which may have a substituent,
the substituent has 1 to 4 carbon atoms, and at least one of methylene groups included in the alkylene group and in the alkyleneoxy group may be replaced by a carbonyl group.

3. The photocurable resin composition for an imprint mold according to claim 1 or 2, wherein the linear alkylene group which may have a substituent has at least one structure represented by the following formula (2), 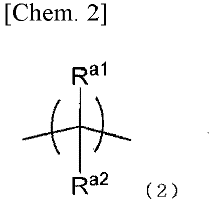
wherein in the formula (2), R^{a1} to R^{a2} are each independently a hydrogen atom or an alkyl group having 1 to 4 carbon atoms, and
the alkyleneoxy group which may have a substituent has at least one structure represented by the following formula (3), 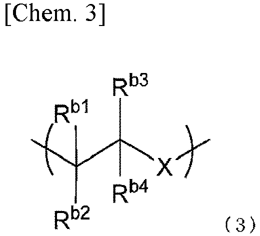
wherein R^{b1} to R^{b4} are each independently a hydrogen atom or an alkyl group having 1 to 4 carbon atoms, and X is an oxygen atom or a sulfur atom,
at least one of methylene groups included in the alkylene group and in the alkyleneoxy group may be replaced by a carbonyl group, and
when the divalent organic group has two or more structures represented by the formula (2) and/or two or more structures represented by the formula (3), R^{a1} to R^{a2} and R^{b1} to R^{b4} may be same as or different from each other.

4. The photocurable resin composition for an imprint mold according to any one of claims 1 to 3, wherein the component (a) is at least one of: a fluorinated (meth)acrylate monomer having at least one (meth)acryloyloxy group and a fluorine content of 34 to 65 mass%; and the dialkylsiloxane-based (meth)acrylate monomer having at least one (meth)acryloyloxy group.

5. The photocurable resin composition for an imprint mold according to any one of claims 1 to 4, further comprising at least one component (c) selected from the group consisting of: an acyclic bifunctional (meth)acrylate monomer having a hydroxyl group and two (meth)acryloyloxy groups; a urethane-based bifunctional (meth)acrylate monomer having two (meth)acryloyloxy groups; and a cyclic bifunctional (meth)acrylate monomer having a ring structure and two (meth)acryloyloxy groups,
wherein the monomer of component (c) is a different monomer from the component (a) and the component (b), and
the ring structure of the cyclic bifunctional (meth)acrylate monomer is at least one selected from the group consisting of an alicyclic ring, a heterocyclic ring, an aromatic ring and a heteroaromatic ring.

6. The photocurable resin composition for an imprint mold according to claim 5, wherein the component (c) is at least one of: a urethane based bifunctional (meth)acrylate monomer having two (meth)acryloyloxy groups; and a cyclic bifunctional (meth)acrylate monomer having a ring structure and two (meth)acryloyloxy groups.

7. The photocurable resin composition for an imprint mold according to any one of claims 1 to 6, wherein the acyclic bifunctional (meth)acrylate monomer is an acyclic bifunctional acrylate monomer.

8. The photocurable resin composition for an imprint mold according to any one of claims 1 to 7, wherein an amount of a monofunctional monomer in a total monomer content of the photocurable resin composition for an imprint mold is 50 mass% or less.

9. The photocurable resin composition for an imprint mold according to any one of claims 1 to 8, wherein an amount of the component (a) is from 1 to 35 mass% on a major component basis of the photocurable resin composition for an imprint mold.

10. The photocurable resin composition for an imprint mold according to any one of claims 1 to 9, wherein an amount of the component (b) is 1 to 96 mass% on a major component basis of the photocurable resin composition for an imprint mold.

11. The photocurable resin composition for an imprint mold according to any one of claims 5 to 10, wherein an amount of the component (c) is 1 to 96 mass% on a major component basis of the photocurable resin composition for an imprint mold.

12. A resin mold obtained by curing the photocurable resin composition for an imprint mold according to any one of claims 1 to 11 so as to have a plurality of concave-convex patterns.

13. A pattern forming method, comprising:
a step of forming a transfer layer on a base material using a photocurable resin composition for imprint transfer;
a step of contacting the resin mold according to claim 12 with a surface of the transfer layer; and
a step of forming a concave-convex pattern by irradiating the transfer layer with light.

14. A composite, comprising:
the resin mold according to claim 12; and
a photocured layer formed by irradiating a transfer layer formed by using a photocurable resin composition for imprint transfer with light in a state where the resin mold is contacted with the transfer layer.

15. A method of forming a composite, the method comprising:
a step of forming a transfer layer on a base material using a photocurable resin composition for imprint transfer;
a step of contacting the resin mold according to claim 12 with a surface of the transfer layer; and
a step of obtaining a composite having the resin mold and a photocured layer by irradiating the transfer layer with light to form the photocured layer having a concave-convex pattern.

16. A method of manufacturing an optical member using the pattern forming method according to claim 13 to manufacture an optical member.
